# EUROPÄISCHE PATENTSCHRIFT

(11) **EP 0 352 552 B1**
(45) Veröffentlichungstag und Bekanntmachung des Hinweises auf die Patenterteilung: **12.01.1994**
(21) Anmeldenummer: 89112801.9
(22) Anmeldetag: 13.07.1989
(51) Int. Cl.: H01J 37/26

(54) **Verfahren zum Beleuchten eines Objektes in einem Transmissions-Elektronenmikroskop und dazu geeignetes Elektronenmikroskop**
Process for illuminating an object in a transmission electron microscope and electron microscope suitable for that process
Procédé d'éclairement d'un objet dans un microscope électronique à transmission et microscope électronique apte à la mise en ouvre du procédé

(30) Priorität: 23.07.1988 DE 3825103
(43) Veröffentlichungstag der Anmeldung: 31.01.1990
(73) Patentinhaber: Firma Carl Zeiss, D-73446 Oberkochen (DE)
(72) Erfinder: Benner,Gerd Dr., D-7080 Aalen (DE)

(56) Entgegenhaltungen:
- FR-A- 2 153 346
- US-A- 3 560 781
- OPTIK. Band 48, Nr. 1, 1977, Stuttgart,DE;Seiten 95 - 118; J.R.A.CLEAVER: "An illumination system for a 600kV high resolution electron microscope with a condenser-objective lens"

## Beschreibung

Die vorliegende Erfindung betrifft ein Verfahren zum Beleuchten eines Objektes in einem Transmissions-Elektronenmikroskop nach dem Oberbegriff des Patentanspruches 1 und ein Transmissions-Elektronenmikroskop nach dem Oberbegriff des Anspruchs 9.

Moderne Elektronenmikroskope werden meist mit einer sogenannten Kondensor-Objektiv-Einfeld-Linse (KOE-Linse) nach Riecke und Ruska ausgerüstet, die z.B. aus der DE-PS 875 555 bekannt ist. Bei ihr ermöglicht die symmetrische Objektlage in der Spaltmitte des Polschuhes bei geeigneter Einstrahlung sowohl den hochauflösenden Transmissions-Betrieb (TEM-Betrieb) als auch die Erzeugung sehr kleiner Elektronensonden für den Scanning-Transmissions-Betrieb (STEM-Betrieb) und die Feinbereichsbeugung. Beim TEM-Betrieb bildet die letzte Kondensorlinse die Elektronenquelle in den vorderen Brennpunkt der KOE-Vorfeldlinse ab und bewirkt dadurch die achsenparallele Ausleuchtung des Objektes. Die Größe des Beleuchtungsfeldes vom Objekt wird dabei vom Durchmesser der sog. Kondensorblende (Beleuchtungsfeldblende) bestimmt. Beim STEM-Betrieb wird die Elektronenquelle durch die letzte Kondensorlinse in die Abbildungsebene der KOE-Vorfeldlinse abgebildet, welche die Elektronenquelle verkleinert in das Objekt abbildet.

Diese TEM-Ausleuchtung hat jedoch den Nachteil, daß die Abbildung der Elektronenquelle in den vorderen Brennpunkt der KOE-Vorfeldlinse streng eingehalten werden muß, andernfalls bewirkt das kurzbrennweitige Vorfeld der KOE-Linse eine extrem schiefe Beleuchtung des außeraxialen Objektbereiches. Die letzte Kondensorlinse kann daher nicht zur Regelung der Größe des Beleuchtungsfeldes vom Objekt und seiner Apertur (Helligkeit) herangezogen werden.

Aus der DE-OS 2 822 242 ist der Einbau einer Zusatzlinse dicht vor der KOE-Linse bekannt, die mit der KOE-Vorfeldlinse ein teleskopisches System bildet. Mit ihr wird eine Beleuchtung des Objektes erreicht, die den bekannten Transmissions-Elektronenmikroskopen entspricht und damit den Nachteil hat, daß Beleuchtungsapertur und Beleuchtungsfeld nicht unabhängig voneinander eingestellt werden können. Zur Erzeugung kleiner Sonden im STEM-Betrieb muß die Zusatzlinse ausgeschaltet oder ihre Wirkung minimiert werden, wodurch sich die Justierung der KOE-Linse verändern kann.

Eine unabhängige Einstellung von Beleuchtungsapertur und Beleuchtungsfeld des Objektes ist in der DE-PS 1 614 123 angegeben. Dort wird zunächst durch eine kurzbrennweitige, erste Kondensorlinse ein stark verkleinertes Bild der Elektronenquelle (Crossover) erzeugt und dieses Bild durch eine langbrennweitige, zweite Kondensorlinse in die Brennebene der KOE-Vorfeldlinse abgebildet. Hinter der zweiten Kondensorlinse liegt die Beleuchtungsfeldblende, welche durch die KOE-Vorfeldlinse scharf in die Objektebene abgebildet wird und damit die Größe des beleuchteten Objektbereiches bestimmt. Die Beleuchtungsapertur ist gegeben durch die Größe des Crossovers in der Brennebene der KOE-Vorfeldlinse und wird durch das Maß der Verkleinerung der ersten Kondensorlinse verändert, die dazu wahlweise einsetzbare, unterschiedliche Bildweiten bewirkende Polschuhsysteme hat.

Nachteilig an dieser bekannten Lösung ist, daß die wahlweise einsetzbaren Polschuhsysteme mechanisch sehr aufwendig sind, der Nachjustierung bedürfen und nur eine geringe Variation der Beleuchtungsapertur in wenigen Stufen erlauben. Für die Änderung der Beleuchtungsfeldblende sind in der angegebenen Veröffentlichung keine Angaben gemacht, so daß nur die bekannten Wechselanordnungen mit dem Nachteil der notwendigen Nachjustierung in Frage kommen, was bei Routinearbeiten für den Benutzer äußerst lästig und wegen der Lage der Blenden kaum zumutbar ist.

Eine optimale Beleuchtung des Objekts in einem Transmissions-Elektronenmikroskop muß folgende Forderungen erfüllen:
- Die Beleuchtungsapertur (Öffnungswinkel des beleuchtenden Strahlenkegels) muß variabel sein, um die Kohärenz der Beleuchtung, die Bildhelligkeit und den Kontrast dem jeweiligen Objekt anpassen zu können.
- Die Größe des beleuchteten Objektbereichs (Beleuchtungsfeld) darf nur wenig größer als der abgebildete Objektbereich sein, um unnötige Objektschädigung und kontrastvermindernde Streuelektronen zu vermeiden.
- Die Einstellungen von Beleuchtungsapertur und Beleuchtungsfeldgröße müssen unabhängig voneinander sein.
- Der Beleuchtungsstrahlenkegel muß möglichst senkrecht auf jeden Objektpunkt treffen, um Bildverzerrungen durch schiefe Beleuchtung im außeraxialen Bereich zu verhindern.
- Das Beleuchtungsfeld muß gleichmäßig und strukturlos ausgeleuchtet werden.

In der Lichtmikroskopie werden diese Anforderungen an ein Beleuchtungssystem durch die sog. Köhlersche Beleuchtung erfüllt. In der Elektronenmikroskopie ist dieses Prinzip trotz seiner klar ersichtlichen Vorteile bisher nur in Ausnahmefällen bei einzelnen Vergrößerungseinstellungen angewendet worden, da es für elektronenoptische Systeme keine im Durchmesser variablen Blenden mit der erforderlichen Kantenreinheit gibt, und somit ein ständiger Wechsel der Blenden erforderlich wäre. Dieser Wechsel ist jedoch wegen der Lage der Blenden, des Zeitaufwandes für den Wechsel und der notwendigen Nachjustierungen nach jedem Wechsel im Routinebetrieb nicht akzeptabel.

Die Aufgabe der vorliegenden Erfindung ist, für ein Transmissions-Elektronenmikroskop ein Beleuchtungsverfahren anzugeben, das der Köhlerschen Beleuchtung in einem großen Vergrößerungsbereich bei einfacher Handhabung entspricht. Außerdem soll das Beleuchtungsverfahren die Erzeugung von Elektronenstrahlsonden mit sehr kleinem Durchmesser für die Mikroanalyse und den STEM-Betrieb ermöglichen. Außerdem soll ein Transmissions-Elektronenmikroskop angegeben werden, bei dem eine solche Köhlersche Beleuchtung einstellbar ist.

Die gestellte Aufgabe wird erfindungsgemäß durch ein Verfahren mit den Merkmalen des Anspruches 1 und durch ein Transmissions-Elektronenmikroskop mit den Merkmalen des Anspruchs 9 gelöst. Vorteilhafte Ausgestaltungen der Erfindung gehen aus den abhängigen Ansprüchen und den beschriebenen Ausführungsbeispielen hervor.

Wesentliche Merkmale der Erfindung sind:
- Mindestens zwei der Kondensorlinsen werden derart verwendet, daß sie die Elektronenquelle mit unterschiedlicher, vorgebbarer Verkleinerung abbilden. Im TEM-Betrieb wird dadurch die Beleuchtungsapertur eingestellt; im STEM-Betrieb wird dadurch die Größe des abtastenden Elektronenstrahles auf der Probe gewählt.
- Der Elektronenstrahl wird im TEM-Betrieb durch mindestens zwei in unterschiedlichen Ebenen angeordnete Blenden beschnitten und durch mindestens ein Ablenksystem beeinflußt. Dabei bleibt sowohl die zentrale Lage des Beleuchtungsfeldes als auch die senkrechte Einstrahlung erhalten. Die Größe des Beleuchtungsfeldes auf dem Objekt wird an die Vergrößerung des Objektes durch das Elektronenmikroskop angepaßt, wobei das Beleuchtungsfeld jeweils nur etwas größer ist als jener Bereich des Objektes, der vom Elektronenmikroskop vergrößert auf dem Leuchtschirm, einer Photoplatte oder einem elektronischen Bildaufzeichnungssystem abgebildet wird.

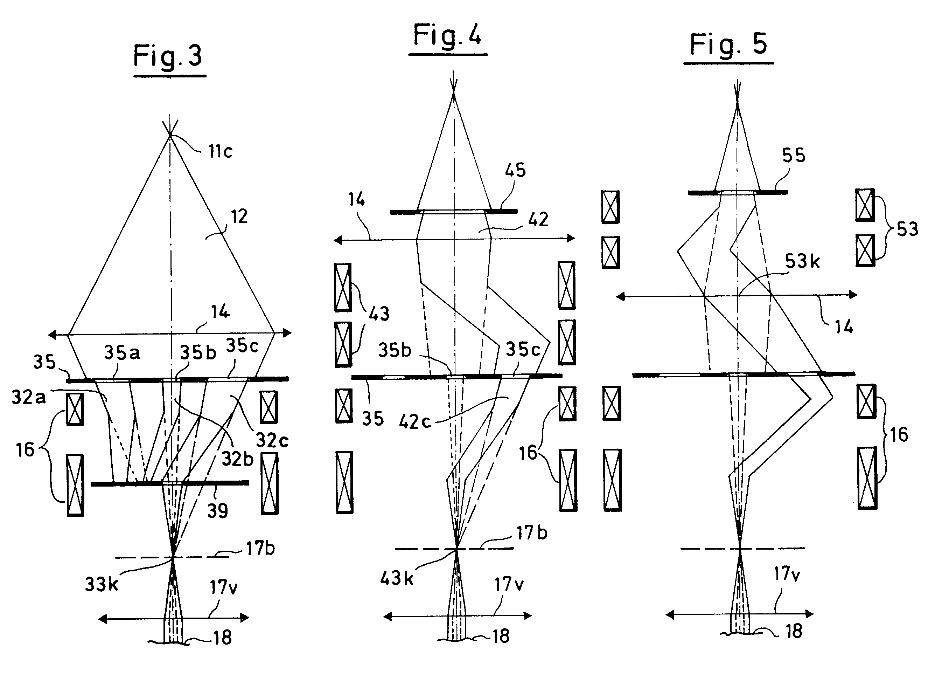

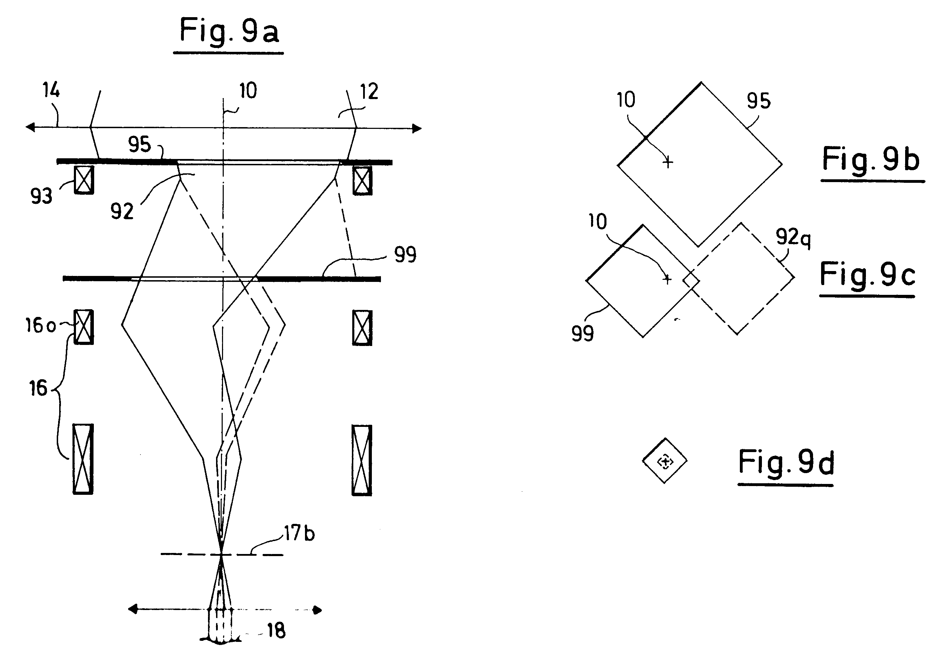

In einer besonders einfachen Anordnung (Figur 3) wird als einziges Ablenksystem das ohnehin vorhandene Ablenksystem vor der KOE-Linse benutzt, das für die Zentrierung des Elektronenstrahles vor dem Eintritt in die KOE-Linse und zur Auslenkung bzw. Rasterung des Elektronenstrahles im STEM-Betrieb und für die Mikroanalyse bekannt ist. In anderen vorteilhaften Ausführungsformen (Figur 4 bis 8) wird ein zusätzliches Ablenksystem verwendet, mit dem der Elektronenstrahl aus der optischen Achse z.B. in unterschiedlichen Richtungen ausgelenkt und anschließend durch eine von mehreren unterschiedlich großen Blenden beschnitten wird. Das Ablenksystem vor der KOE-Linse dient in diesen Fällen dazu, den beschnittenen Elektronenstrahl wieder in die optische Achse zurückzulenken. Bei weiteren vorteilhaften Ausführungsformen (Figur 9 bis 11) wird der Elektronenstrahl durch ein zusätzliches Ablenksystem ebenfalls aus der optischen Achse ausgelenkt und durch zwei in verschiedenen Ebenen angeordnete Blenden auf einander gegenüberliegende Seiten entsprechend der Stärke der Auslenkung unterschiedlich stark beschnitten und anschließend durch das Ablenksystem vor der KOE-Linse wieder in die optische Achse zurückgelenkt.

Veränderungen des Querschnittes eines Elektronenstrahles durch Auslenkung aus der optischen Achse und die Beschneidung durch Blenden sind aus der Elektronenstrahl-Lithographie bekannt, jedoch nicht in Verbindung mit einer KOE-Linse.Im Gegensatz zu der vorliegenden Erfindung handelt es sich dort jedoch um einen wesentlich kleineren Variationsbereich für die Größe des Beleuchtungsfeldes (ca. 1 µm an Stelle von 1 bis mindestens 100 µm). Aufgrund der erforderlichen Kantenschärfe von < 0,1 µm wird bei den Lithographieeinrichtungen der Strahlquerschnitt dicht unterhalb des Strahlerzeugers geformt und dann stark verkleinert auf das Substrat abgebildet. Bei den Lithographieeinrichtungen muß die Richtung der auf das Substrat fallenden Strahlung nicht senkrecht und unabhängig von der Größe des Beleuchtungsfeldes sein. Es erfolgt daher keine Rücklenkung des beschnittenen Elektronenstrahles in die optische Achse. Und schließlich kann bei Lithographieeinrichtungen der Aperturwinkel der auf das Substrat fallenden Strahlung nicht variabel eingestellt werden, sondern die erforderliche Strahlungsdosis für die Erzeugung der Mikrostrukturen wird über die Belichtungszeit eingestellt.

Ein elektronenoptisches System zur Erzeugung eines Formstrahles mit variablem Querschnitt für die Herstellung von Mikrostrukturen ist aus der EP-B1-0 075 bekannt. Bei diesem wird der durch eine erste Schlitzblende beschnittene Elektronenstrahl mit Hilfe eines Ablenksystems abgelenkt und auf einer zweiten Schlitzblende verschoben, so daß hinter der zweiten Schlitzblende der Elektronenstrahl einen rechteckförmigen Querschnitt mit den gewünschten Abmessungen hat. Dabei wird nur die Größe des Beleuchtungsfeldes auf dem Halbleiter verändert; die Apertur des Elektronenstrahles kann nicht variiert werden.

Aus der WO-A-8 002 771 ist ein elektronenoptisches System bekannt, mit dem die Apertur eines Elektronenstrahles dadurch verändert wird, daß der Elektronenstrahl durch ein erstes Ablenksystem aus der optischen Achse ausgelenkt, durch eine von mehreren in einer Ebene angeordnete Blenden beschnitten und durch ein zweites Ablenksystem wieder in die optische Achse zurückgelenkt wird. In diesem Fall wird nur die Apertur des Elektronenstrahles verändert.

Die Erfindung wird im folgenden anhand von in den Figuren 1 bis 12 dargestellten Ausführungsbeispielen naher erläutert. Dabei zeigen:
- Figur 1: den Beleuchtungsstrahlengang eines Elektronenmikroskopes im TEM-Betrieb;
- Figur 2: den Beleuchtungsstrahlengang desselben Elektronenmikroskopes im STEM-Betrieb;
- Figur 3: eine Anordnung für die Auswahl einer von mehreren Blenden als Beleuchtungsfeldblende ohne zusätzliches Ablenksystem;
- Figur 4 bis 8: Anordnungen für die Auswahl einer von mehreren Blenden als Beleuchtungsfeldblende mit einem zusätzlichen Ablenksystem;
- Figur 9 bis 11: Anordnungen für die Beschneidung des Elektronenstrahles auf einander gegenüberliegenden Seiten durch zwei in verschiedenen Ebenen angeordneten Blenden und
- Figur 12: ein Blockschaltbild für den automatischen Betrieb eines Elektronenmikroskopes mit jeweils optimaler Größe des Beleuchtungsfeldes vom Objekt.

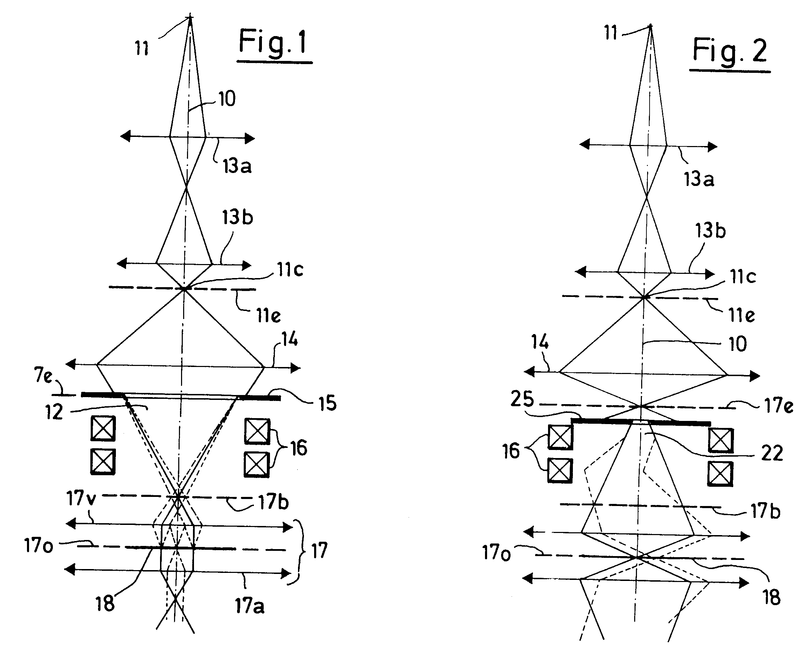

In Figur 1 ist der Beleuchtungsstrahlengang bei TEM-Betrieb dargestellt. Mit (11) ist die Elektronenquelle bezeichnet, bzw. - exakt ausgedrückt - der kleinste Strahlquerschnitt (Crossover) vor der emittierenden Kathodenfläche. Dieser Crossover wird durch die Kondensoren (13a,13b und 14), die auf der gemeinsamen optischen Achse (10) liegen, verkleinert abgebildet. Die Kondensoren (13a,13b) werden jeweils so erregt, daß in der Ebene (11e) ein Bild (11c) des Crossovers (11) erzeugt wird, dessen Größe von der jeweiligen Erregung der Kondensoren (13a,13b) abhängt. Das Bild (11c) des Crossovers (11), das meist ebenfalls nur als Crossover bezeichnet wird, wird im TEM-Betrieb durch den Kondensor (14) in die Brennebene (17b) der KOE-Vorfeldlinse (17v) abgebildet; das Objekt (18) in der Objektebene (17o) wird daher mit zur optischen Achse (10) parallelen Strahlen beleuchtet. Die Beleuchtungsapertur ist somit gegeben durch die Größe des Crossoverbildes in der Brennebene (17b) und die Brennweite der KOE-Vorfeldlinse (17v) und kann daher durch unterschiedliche Erregung der Kondensorlinsen (13a,13b) in einem weiten Bereich verändert werden.

Zwischen der letzten Kondensorlinse (14) und der KOE-Linse (17) ist eine Beleuchtungsfeldblende (15) so angeordnet, daß sie durch die KOE-Vorfeldlinse (17v) mindestens annähernd scharf in die Objektebene (17o) abgebildet wird. Die Größe des ausgeleuchteten Bereiches wird daher durch den Durchmesser der Beleuchtungsfeldblende und ihrer Verkleinerung durch die KOE-Vorfeldlinse (17v) bestimmt. In der Beleuchtungsfeldblende 15), die häufig auch als Kondensorblende oder Leuchtfeldblende bezeichnet wird, hat bei dem in Figur 1 dargestellten Strahlengang, das (gestrichelt gezeichnete) Strahlenbündel, welches die Größe der Beleuchtungsapertur bestimmt, seinen engsten Querschnitt, so daß eine Änderung des Beleuchtungsfeldes auf dem Objekt (18) durch die Beleuchtungsfeldblende (15) keinen Einfluß auf die Beleuchtungsapertur hat. Außerdem ist auch die Größe des Beleuchtungsfeldes unabhängig von der Größe des Crossoverbildes in der Brennebene (17b), so daß Beleuchtungsfeld und Beleuchtungsapertur vollig unabhängig voneinander sind.

Vor der Kondensor-Objektiv-Einfeld-Linse (KOE-Linse) (17), die - wie bekannt - aus der KOE-Vorfeldlinse (17v) und der KOE-Abbildungslinse (17a) besteht ist ein Ablenksystem (16) angeordnet, das dazu dient, geringe Abweichungen des Elektronenstrahles (12) gegenüber der Achse der KOE-Linse (17) zu korrigieren. Dieses bekannte Ablenksystem wird zur Unterscheidung gegenüber einem später eingeführten im folgenden immer als "Ablenksystem (16) vor der KOE-Linse" bezeichnet.

Figur 2 zeigt den Strahlenverlauf beim STEM-Betrieb oder bei Feinbereichsbeugung. Alle Linsen, das Ablenksystem (16) vor der KOE-Linse und das Objekt (18) in der Objektebene (170) sind in derselben Lage wie beim TEM-Betrieb in Figur 1 und daher mit dem gleichen Bezugszeichen bezeichnet.

Im Gegensatz zu Figur 1 bildet die Kondensorlinse (14) im STEM-Betrieb oder bei Feinbereichsbeugung den Crossover (11e) in die Eingangsbildebene (17e) der KOE-Vorfeldlinse (17v) ab, so daß ein stark verkleinertes Bild der Elektronenquelle (11) auf dem Objekt (18) entsteht. Dieses verkleinerte Bild wird durch das Ablenksystem (16) vor der KOE-Linse in der Objektebene (17o) bewegt, wie die gestrichelten Linien für einen zweiten Punkt auf dem Objekt (18) zeigen. Die Apertur des die Probe (18) abtastenden Elektronenstrahles (22) wird durch eine Blende (25) oberhalb oder unterhalb der Ebene (17e) begrenzt. Diese Blende kann auch in der Ebene (17b) angeordnet sein, wenn dort beim STEM-Betrieb nicht der Platz durch Detektoren belegt ist oder die Detektion von Sekundärelektronen oder Röntgenstrahlen behindert wird. Die Größe des abtastenden Elektronenstrahles auf der Probe (18) kann durch unterschiedliche Erregung der beiden Kondensorlinsen (13a und 13b) in einem weiten Bereich verändert werden.

Ein derartiges Zoom für den STEM-Betrieb ist aus einer Veröffentlichung von D. Kurz u. M. (Zeiss Information MEM Nr. 4, S. 4, Sept. 1985) bekannt. Es wird im vorliegenden Fall auch im TEM-Betrieb zur Veränderung der Beleuchtungsapertur verwendet. Damit im TEM- und STEM-Betrieb dieselbe Kondensoranordnung benutzt werden kann, muß die Verkleinerung der letzten Kondensorlinse (14) im TEM-Betrieb ca. 4 mal geringer sein als im STEM-Betrieb. Daher wirkt die letzte Kondensorlinse (14) im TEM-Betrieb ca. 1,3fach vergrößernd und im STEM-Betrieb ca. 3fach verkleinernd. Für die vorliegende Aufgabe ist z.B. folgende Dimensionierung vorteilhaft:
Brennweite Kondensorlinse (13a): 3,5 bis 45 mm
Brennweite Kondensorlinse (13b): 3,5 bis 13,0 mm
Abstand Crossover (11) bis Kondensorlinse (13a): 130 mm
Abstand Kondensorlinse (13a) bis Kondensorlinse (13b): 75 mm
Für eine Bildweite (Abstand Kondensorlinse (13b) bis Bildebene 11e)) von 16 mm ergibt sich damit ein Verkleinerungsbereich für das Bild des Crossovers von 0,5 bis 160. Für Bildweiten von 8 und 4 mm ergeben sich Verkleinerungsbereiche von 1,6 bis 320 und 20 bis 630.

Beim TEM-Betrieb muß die Blende (15) (Figur 1) sehr unterschiedliche Durchmesser haben, damit für einen großen Vergrößerungsbereich des Elektronenmikroskopes jeweils nur eine Fläche beleuchtet wird, die wenig größer ist als die auf dem Endbildleuchtschirm bzw. anderen Bildaufzeichnungssystemen abgebildete Fläche. In den Figuren 3 bis 9 sind anhand von Ausführungsbeispielen Verfahren beschrieben, mit denen ein auch für den Routinebetrieb geeigneter Blendenwechsel oder geeignete Blendenanderungen durchgeführt werden können. Alle beschriebenen Ausführungsbeispiele lassen sich automatisieren und mit der Vergrößerungseinstellung des Elektronenmikroskopes koppeln.

Figur 3 zeigt eine besonders einfache Anordnung zur Realisierung von mehreren Blenden mit unterschiedlichem Durchmesser und damit unterschiedlich großen Beleuchtungsfeldern auf dem Objekt (18). Mit (11c) ist wieder der Crossover vor der letzten Kondensorlinse (14) bezeichnet. Der durch die Kondensorlinse (14) in die vordere Brennebene (17b) der KOE-Linse (17v) fokussierte Elektronenstrahl (32) beleuchtet großflächig eine Mehrfachblende (35), die aus mehreren unterschiedlich großen Blenden (35a,35b,35c) besteht. Die durch diese Blenden hindurchtretenden Teilstrahlen (32a,32b,32c) fallen auf eine zentrisch angeordnete Selektorblende (39), durch welche entsprechend der Erregung des Ablenksystems (16) vor der KOE-Linse jeweils nur einer der Teilstrahlen durchgelassen wird. In der Figur 3 ist dies mit ausgezogenen Linien für den von der größten Blende (35c) durchgelassenen Teilstrahl (32c) dargestellt.

Wie auch in den folgenden Beispielen ist die kleinste Blende (35b) vorzugsweise zentrisch und die übrigen Blenden (35a,35c) sind ringförmig um sie herum angeordnet. Für die Benutzung der kleinsten Blende gelten die gestrichelten Linien. Mit Hilfe der Selektorblende (39) und des Ablenksystems (16), dessen Kippunkt (33k) in der vorderen Brennebene (17b) der KOE-Linse (17v) liegt, wird also erreicht, daß nur die gewünschte Blende zentral auf das Objekt (18) abgebildet wird.

Figur 4 zeigt eine Anordnung, bei welcher der von einer Begrenzungsblende (45) begrenzte Elektronenstrahl (42) durch ein zusätzliches Ablenksystem (43) auf die gewünschte Blende der Mehrfachblende (35) abgelenkt wird. Der Strahlengang für diejenigen Erregungszustände der Ablenksysteme (43) und (16), bei denen die größte Blende (35c) wirksam wird, ist wieder mit ausgezogenen Linien gezeichnet und derjenige Fall, bei dem die kleinste Blende (35b) wirksam wird, ist wieder mit gestrichelten Linien gezeichnet. Das zusätzliche Ablenksystem (43) besteht aus einem Doppelablenksystem, dessen Kippunkt (43k) vorzugsweise in der Brennebene (17b) der KOE-Linse (17v) liegt. In diesem Fall erfolgt die Rücklenkung des Teilstrahles (42c) durch das Ablenksystem (16) vor der KOE-Linse in der üblichen Betriebsweise dieses Ablenksystems.

Die in Figur 4 gezeigte Anordnung erfordert einen verhältnismäßig großen Platzbedarf, damit die Ablenkwinkel im zusatzlichen Ablenksystem (43) ausreichend klein gehalten werden können. Ohne zusätzlichen Platzbedarf kommt die in Figur 5 gezeigte Anordnung aus, bei welcher das zusätzliche Ablenksystem (53) vor der letzten Kondensorlinse (14) angeordnet ist. Der Kippunkt (53k) des Doppelablenksystems (53) liegt in der nahezu konstanten Hauptebene der letzten Kondensorlinse (14), damit diese Linse mit variabler Brennweite betrieben werden kann.

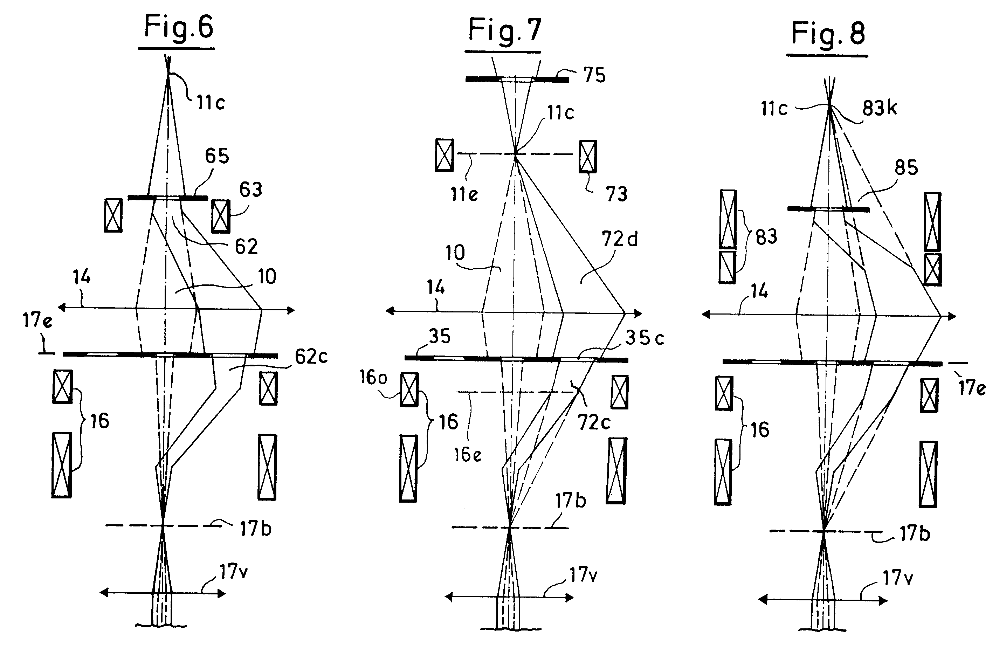

Bei den in den Figuren 6 bis 8 dargestellten Anordnungen liegt das zusätzliche Ablenksystem ebenfalls vor der letzten Kondensorlinse (14), welche jetzt aber konstant erregt wird und noch zusätzlich eine rücklenkende Wirkung auf den ausgelenkten Elektronenstrahl hat.

In Figur 6 ist das zusätzliche Ablenkelement (63) in der vorderen Brennebene der letzten Kondensorlinse (14) angeordnet. Daher wird der von der Begrenzungsblende (65) begrenzte Elektronenstrahl (62) durch das Ablenkelement (63) und die letzte Kondensorlinse (14) parallel verschoben. Nach dem Passieren der gewünschten Blende wird der Elektronenstrahl (62c) durch das Ablenksystem (16) vor der KOE-Linse wieder auf die optische Achse (10) zurückgelenkt. Bei dieser Anordnung ist, ebenso wie bei der in Figur 7 dargestellten, lediglich ein zusätzliches Ablenkelement erforderlich.

In Figur 7 ist das zusätzliche Ablenkelement (73) in der Crossoverebene (11e) (Bildebene des Kondensorzooms) vor der letzten Kondensorlinse (14) angeordnet, und die Begrenzungsblende (75) liegt vor dieser Bildebene. Das abgelenkte Strahlenbündel (72d) wird durch die letzte Kondensorlinse (14) in die Brennebene (17b) der KOE-Linse (17v) fokussiert. Das Ablenksystem (16) vor der KOE-Linse lenkt den z.B. von der Blende (35c) begrenzten Elektronenstrahl (72c) wieder in die optische Achse (10) zurück.

Mit der in Figur 7 gezeigten Anordnung ist auch die Ausleuchtung sehr größer Objektbereiche möglich: Wenn bei niedrigen Vergrößerungen im Transmissionsbetrieb der Crossover (11c) naher an die Begrenzungsblende (75) gelegt wird, dann wirkt die Blende weniger strahlbegrenzend, so daß bei aus dem Strahlengang genommener Mehrlochblende (35) sehr Größe Objektbereiche ausgeleuchtet werden können. Die Größe des Beleuchtungsfeldes hängt von dem Durchmesser der Begrenzungsblende (75) und ihrem Abstand von der Crossoverebene (11e) ab. Eine Änderung des Abstandes der Crossoverebene (11e) von der Begrenzungsblende (75) beeinflußt nur die Größe des Beleuchtungsfeldes. Durch eine Änderung der Crossoververkleinerung mit den Kondensorlinsen (13a, 13b) bei Konstanz der Crossoverebene (11e) des Kondensorzooms läßt sich die Beleuchtungsapertur variieren, ohne die Größe des Beleuchtungsfeldes zu ändern. Mit einer Begrenzungsblende (75) von 200 - 250 µm in der Hauptebene der Kondensorlinse (13b) ergeben sich z.B. für Bildweiten des Kondensorzooms (Abstand Crossoverebene (11e) bis Kondensorlinse (13b)) von 4, 8 und 16 mm Beleuchtungsfelder auf dem Objekt von ca. 140, 70 und 35 µm, was eine minimale Mikroskopvergrößerung von 1000, 2000 und 4000fach zuläßt.

Ein automatisierter Blendenwechsel ist auch für Mikroskopvergrößerungen ≦ 1000fach möglich. Bei diesen kleinen Vergrößerungen (sog. Low-Mag-Mode) wird die KOE-Linse einschließlich der KOE-Vorfeldlinse (17v) sehr langbrennweitig betrieben, wie aus der DE-PS 27 42 264 bekannt ist. Für diesen Fall bildet die letzte Kondensorlinse (14) den Crossover (11c) - mit variabler Vergrößerung durch die Kondensorlinsen (13a, 13b) - in die Mittelebene (16e) des oberen Ablenksystems (16o) vom Ablenksystem (16) vor der KOE-Linse ab. Die KOE-Vorfeldlinse (17v) wird so erregt, daß ihr Brennpunkt ebenfalls in dieser Ebene (16e) liegt. Dadurch wird das Objekt (18) achsenparallel beleuchtet, und die Beleuchtungsapertur wird bestimmt durch die Größe des Crossovers in der Mittelebene (16e). Die Mehrfachblende (35) ist in diesem Fall möglichst nahe an der Hauptebene der letzten Kondensorlinse (14) angeordnet und ermöglicht durch entsprechende Auslenkungen des Elektronenstrahles mit Hilfe des Ablenksystems (73) und Rücklenkungen durch das obere Ablenksystem (16o) unterschiedlich Große Beleuchtungsfelder auf dem Objekt.

Ein ähnlicher Strahlengang wie in Figur 7 ergibt sich, wenn, wie in Figur 8 dargestellt, das zusätzliche Ablenksystem in Form eines Doppelablenksystemes (83) nach dem Crossover (11c) vor der letzten Kondensorlinse (14) angeordnet wird. Der virtuelle Kippunkt (83k) dieses Doppelablenksystems liegt im Crossover (11c). Die Begrenzungsblende (85) kann vor oder hinter dem Crossover (11c) liegen.

In den Figuren 9 bis 11 sind Ausführungsbeispiele dargestellt, bei denen der Elektronenstrahl durch ein zusätzliches Ablenksystem aus der optischen Achse in einer Richtung mit unterschiedlicher Stärke abgelenkt und sein Querschnitt durch zwei in verschiedenen Ebenen außeraxial angeordnete Blenden auf einander gegenüberliegenden Seiten entsprechend der Stärke der Ablenkung mehr oder weniger stark beschnitten wird.

Figur 9 zeigt ein Ausführungsbeispiel mit nur einem zusätzlichen Ablenksystem (93), das nach der letzten Kondensorlinse (14) angeordnet ist. Der Elektronenstrahl (12) wird vor diesem Ablenksystem von der außeraxial angeordneten Blende (95), deren Querschnitt und Lage zur optischen Achse (10) in der Figur 9b dargestellt ist, beschnitten. Der weitere Verlauf des beschnittenen Elektronenstrahles (92) ist mit ausgezogenen Linien für ein großes und mit unterbrochenen Linien für ein kleines Beleuchtungsfeld dargestellt. Der von der ersten außeraxialen Blende (95) einseitig geformte Strahlquerschnitt (92) wird durch das zusätzliche Ablenksystem (93) so abgelenkt, daß er eine zweite außeraxiale Blende (99), deren Querschnitt und Lage zur optischen Achse (10) in Figur 9c dargestellt ist, unterschiedlich ausleuchtet. Im Falle der ausgezogenen Linien erfolgt die Ablenkung derart, daß der Elektronenstrahl (92) von der Blende (99) nicht beschnitten wird; im Falle der unterbrochenen Linien ist der Querschnitt (92q) des Elektronenstrahles in der Ebene der Blende (99) derart verschoben, daß nur ein kleiner Teil durch die Blende durchgelassen wird. Figur 9d zeigt die Querschnitte des Elektronenstrahles nachdem dieser wieder durch das Ablenksystem (16) vor der KOE-Linse in die optische Achse zurückgelenkt wurde.

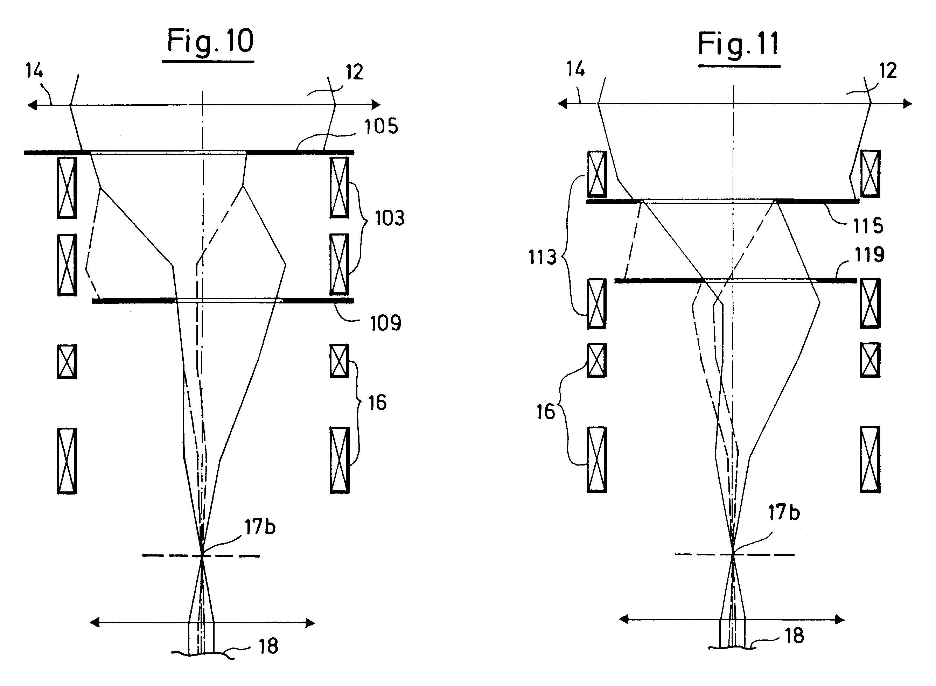

Bei der beschriebenen Ausführungsform ist ein anderer Ablenkmode des Ablenksystems (16) vor der KOE-Linse als bei der üblichen Betriebsweise erforderlich. Außerdem treten beim ersten Ablenkelement (16o) im Gegensatz zum Normalbetrieb Große Ablenkwinkel bei großen Achsabständen auf. Dieser Nachteil wird durch die in den Figuren 10 und 11 verwendeten Doppelablenksysteme (103) und (113) vermieden, deren Kippunkt in der Brennebene (17b) der KOE-Vorfeldlinse liegt. Bei dem in Figur 10 dargestellten Ausführungsbeispiel sind die außeraxialen Blenden (105) und (109) vor und nach dem Doppelablenksystem (103) angeordnet. In Figur 11 befinden sich die außeraxialen Blenden (115) und (119) innerhalb des Doppelablenksystems (113). Die letzte Ausführungsform hat den Vorteil, daß die außeraxialen Blenden (115) und (119) in einer mechanischen Einheit montiert werden können. Wenn mehrere derartigen Einheiten auf einem gemeinsamen Blendenträger angeordnet sind, dann laßt sich in einer weiteren Ausführungsform für unterschiedliche Vergrößerungsbereiche jeweils das geeignete Blendensystem einschwenken, so daß sich kleine Ablenkwinkel des Doppelablenksystems (113) ergeben.

Bei allen Ausführungsbeispielen ist es vorteilhaft, das Bild (11c) der Elektronenquelle (11) mit dem Zoom aus den Kondensoren (13a, 13b) in eine fest vorgegebene Ebene (11e) abzubilden. Das ist jedoch nicht notwendig; entscheidend ist nur, daß der letzte Crossover des gesamten Kondensorsystems beim TEM-Betrieb immer in der Brennebene (17b) und beim STEM-Betrieb immer in der Eingangsbildebene (17e) der KOE-Vorfeldlinse (17v) liegt. Fur kleine Vergrößerungen kann es durchaus vorteilhaft sein, das Bild (11c) der Elektronenquelle (11) mit dem Zoom aus den Kondensoren (13a, 13b) in eine andere Ebene zu legen, wie im Zusammenhang mit Figur 7 erläutert wurde. Für einen sehr großen Vergrößerungsbereich und großen Aperturbereich des Elektronenmikroskops kann es durchaus vorteilhaft sein, mehrere Ebenen als Ausgangsbildebene für das Kondensorzoom vorzusehen, wie das weiter oben angegebene Beispiel für die Dimensionierung des Zooms und die Ausführungen zur Figur 7 zeigen.

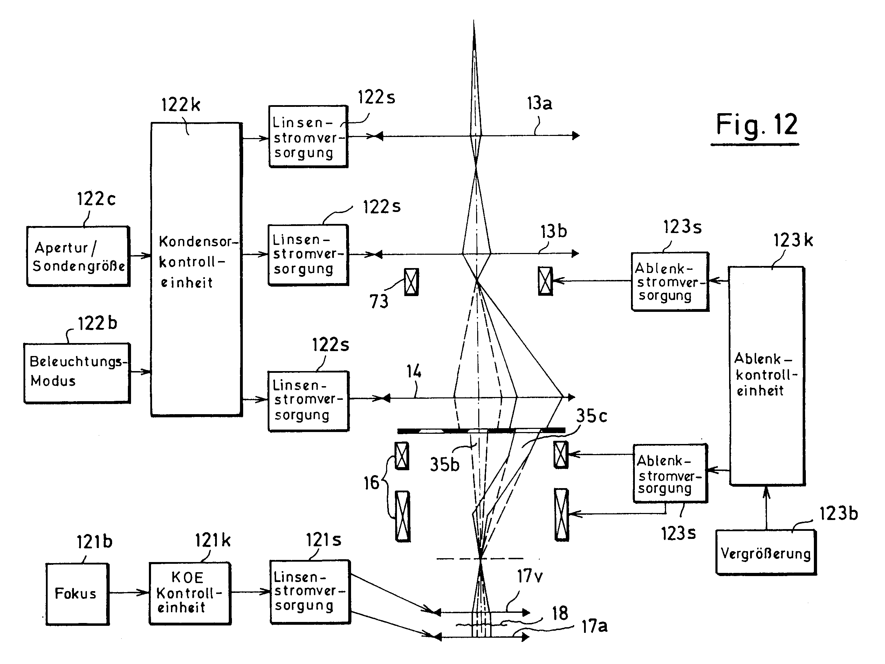

Figur 12 zeigt ein Blockdiagramm für die Stromversorgung und die Bedienelemente des Beleuchtungssystems am Beispiel der in Figur 7 gezeigten Ausführungsform für die Blendenauswahl. Mit (121b) ist das Bedienelement für die Fokuseinstellung bezeichnet, das über die Kontrolleinheit (121k) für die KOE-Linse mit der Stromversorgung (121s) für die KOE-Vorfeldlinse (17v) und die KOE-Abbildungslinse (17a) verbunden ist.

Die Stromversorgungen (122s) der drei Kondensorlinsen (13a, 13b und 14) sind mit einer Kontrolleinheit (122k) verbunden, an welches einerseits das Bedienelement (122b) zur Wahl des TEM-oder STEM-Betriebes und das Bedienelement (122c) zur Regelung der Beleuchtungsapertur beim TEM-Betrieb und zur Regelung der Sondengröße beim TEM-Betrieb angeschlossen sind.

Die Ablenksysteme (16) und (73) sind mit Stromversorgungen (123s) verbunden, die an eine Kontrolleinheit (123k) angeschlossen sind, die ihrerseits mit dem Bedienelement (123b) für die Vergrößerung verbunden sind. Letzteres ist außerdem über eine nicht gezeichnete Kontrolleinheit mit ebenfalls nicht gezeichneten Stromversorgungseinheiten für die Abbildungslinsen des Elektronenmikroskopes verbunden, so daß mit der Einstellung der Vergrößerung des Elektronenmikroskopes automatisch diejenige Beleuchtungsblende (35b, 35c) gewählt wird, welche vom Objekt (18) einen Bereich beleuchtet, der nur wenig größer ist als der vom Elektronenmikroskop vergrößert auf einen Leuchtschirm oder einen Detektor abgebildete Bereich.

Für die in den Figuren 3 bis 6 und 8 bis 11 dargestellten Ausführungsbeispiele gilt das Blockschaltbild der Figur 12 mit gegebenenfalls geringfugigen Änderungen selbstverstandlich auch.

## Patentansprüche

1. Verfahren zum Beleuchten eines Objektes (18) in einem Transmissions-Elektronenmikroskop mit einer Elektronenquelle (11) und mehreren Kondensorlinsen (13a, 13b, 14) zur Erzeugung eines Elektronenstrahles (12), einer Kondensor-Objektiv-Einfeld-Linse (KOE-Linse) (17) und einem Ablenksystem (16) vor der KOE-Linse, dadurch gekennzeichnet, daß mindestens zwei Kondensorlinsen (13a, 13b) derart verwendet werden, daß sie die Elektronenquelle (11) mit unterschiedlicher, vorgebbarer Verkleinerung abbilden, daß der Elektronenstrahl (12, 42) abhängig von der jeweiligen Vergrößerung des Objektes (durch die nachfolgenden Abbildungsstufen des Elektronenmikroskopes) durch mindestens zwei in unterschiedlichen Ebenen angeordnete Blenden (35, 39; 35, 45; 95, 99) in vorgegebenem unterschiedlichem Maß beschnitten wird, daß der beschnittene Elektronenstrahl (42c, 62c, 92c) oder ein Teil (32c) von ihm durch das Ablenksystem (16) vor der KOE-Linse wieder in die optische Achse (1O) zurückgelenkt wird und daß die Beschneidung des Elektronenstrahles (12, 42) abhängig von der jeweiligen Vergrößerung in einem solchen Maß erfolgt, daß vom Objekt (18) immer nur ein Bereich beleuchtet wird, der nicht wesentlich größer als der abgebildete Bereich ist.

2. Verfahren nach Anspruch 1, dadurch gekennzeichnet, daß die letzte Kondensorlinse (14) so erregt wird, daß der Crossover (11c) beim TEM-Betrieb in die Brennebene (17b) und beim STEM-Betrieb in die Eingangsbildebene (17e) der KOE-Vorfeldlinse (17v) abgebildet wird.

3. Verfahren nach Anspruch 1 oder 2, dadurch gekennzeichnet, daß von dem Elektronenstrahl (12) mehrere in einer Ebene angeordnete, unterschiedlich große Blenden (35a, 35b, 35c) beleuchtet werden und daß durch das Ablenksystem (16) vor der KOE-Linse abhängig von der jeweiligen Vergrößerung jeweils nur der durch eine der Blenden (35a, 35b, 35c) hindurchtretende Teilstrahl (32a, 32b, 32c) durch eine weitere, vorzugsweise zentrisch angeordnete Selektorblende (39) auf das Objekt (18) gelenkt wird.

4. Verfahren nach Anspruch 1 oder 2 dadurch gekennzeichnet, daß der von einer Begrenzungsblende (45) begrenzte Elektronenstrahl (42) durch mindestens ein zusätzliches Ablenksystem (43, 53, 63, 73, 83) aus der optischen Achse (10) abhängig von der jeweiligen Vergrößerung in unterschiedlicher Stärke und/oder Richtung abgelenkt und durch eine von mehreren unterschiedlich großen in einer Ebene angeordneten Blenden (35a, 35b, 35c) beschnitten wird.

5. Verfahren nach Anspruch 1 oder 2, dadurch gekennzeichnet, daß der Elektronenstrahl (12) durch mindestens ein zusätzliches Ablenksystem (93, 103, 113) aus der optischen Achse (10) abhängig von der jeweiligen Vergrößerung in unterschiedlicher Stärke abgelenkt und sein Querschnitt durch zwei in verschiedenen Ebenen angeordnete und gegeneinander versetzte Blenden (95, 99; 115, 119) auf einander gegenüberliegenden Seiten entsprechend der Stärke der Ablenkung mehr oder weniger stark beschnitten wird.

6. Verfahren nach Anspruch 4, dadurch gekennzeichnet, daß die letzte Kondensorlinse (14) den von dem Ablenksystem (53, 63, 73, 83) ausgelenkten Elektronenstrahl (42) in Richtung der optischen Achse (10) umlenkt.

7. Verfahren nach Anspruch 6, dadurch gekennzeichnet, daß der durch die Blende (65) begrenzte Elektronenstrahl (42) durch das zusätzliche Ablenksystem (63) und die letzte Kondensorlinse (14) parallel zur optischen Achse (10) verschoben wird.

8. Verfahren nach einem der Ansprüche 1 bis 7, dadurch gekennzeichnet, daß das Ablenksystem (16) vor der KOE-Linse und/oder das zusätzliche Ablenksystem (43;113) zusätzlich zur Korrektur von seitlichen Versetzungen der Blenden (35,39;35,45;95,99) benutzt wird.

9. Transmissions-Elektronenmikroskop mit einer Elektronenquelle (11) und mehreren Kondensorlinsen (13a, 13b, 14) zur Erzeugung eines Elektronenstrahles (12), einer Kondensor-Objektiv-Einfeld-Linse (KOE-Linse) (17) und einem Ablenksystem (16) vor der KOE-Linse, dadurch gekennzeichnet, daß mindestens zwei Kondensorlinsen (13a, 13b) derart verwendet sind, daß sie die Elektronenquelle (11) mit unterschiedlicher, vorgebbarer Verkleinerung abbilden, daß der Elektronenstrahl (12, 42) abhängig von der jeweiligen Vergrößerung eines Objektes (durch die nachfolgenden Abbildungsstufen des Elektronenmikroskopes) durch mindestens zwei in unterschiedlichen Ebenen angeordneten Blenden (35, 39; 35, 45; 95, 99) in vorgegebenem unterschiedlichem Maß beschnitten ist, daß der beschnittene Elektronenstrahl (42c, 62c, 92c) oder ein Teil (32c) von ihm durch das Ablenksystem (16) vor der KOE-Linse wieder in die optische Achse (10) zurückgelenkt ist und daß die Beschneidung des Elektronenstrahles (12, 42) abhängig von der jeweiligen Vergrößerung in einem solchen Maß erfolgt, daß vom Objekt (18) immer nur ein Bereich beleuchtet ist, der nicht wesentlich größer als der abgebildete Bereich ist.

10. Transmissions-Elektronenmikroskop nach Anspruch 9, dadurch gekennzeichnet, daß die letzte Kondensorlinse (14) so erregt ist, daß der Crossover (11c) beim TEM-Betrieb in die Brennebene (17b) und beim STEM-Betrieb in die Eingangsbildebene (17e) der KOE-Vorfeldlinse (17v) abgebildet ist.

11. Transmissions-Elektronenmikroskop nach Anspruch 9 oder 10, dadurch gekennzeichnet, daß von dem Elektronenstrahl (12) mehrere in einer Ebene angeordnete, unterschiedlich große Blenden (35a, 35b, 35c) beleuchtet sind und daß durch das Ablenksystem (16) vor der KOE-Linse abhängig von der jeweiligen Vergrößerung jeweils nur der durch eine der Blenden (35a, 35b, 35c) hindurchtretende Teilstrahl (32a, 32b, 32c) durch eine weitere, vorzugsweise zentrisch angeordnete Selektorblende (39) auf das Objekt (18) gelenkt ist.

12. Transmissions-Elektronenmikroskop nach Anspruch 9 oder 10, dadurch gekennzeichnet, daß der von einer Begrenzungsblende (45) begrenzte Elektronenstrahl (42) durch mindestens ein zusätzliches Ablenksystem (43, 53, 63, 73, 83) aus der optischen Achse (10) abhängig von der jeweiligen Vergrößerung in unterschiedlicher Stärke und/oder Richtung abgelenkt und durch eine von mehreren unterschiedlich großen in einer Ebene angeordneten Blenden (35a, 35b, 35c) beschnitten ist.

13. Transmissions-Elektronenmikroskop nach Anspruch 9 oder 10, dadurch gekennzeichnet, daß der Elektronenstrahl (12) durch mindestens ein zusätzliches Ablenksystem (93, 103, 113) aus der optischen Achse (10) abhängig von der jeweiligen Vergrößerung in unterschiedlicher Stärke abgelenkt und sein Querschnitt durch zwei in verschiedenen Ebenen angeordneten und gegeneinander versetzte Blenden (95, 99; 115, 119) auf einander gegenüberliegenden Seiten entsprechend der Stärke der Ablenkung mehr oder weniger stark beschnitten ist.

14. Transmissions-Elektronenmikroskop nach Anspruch 12, dadurch gekennzeichnet, daß das zusätzliche Ablenksystem aus einem Doppelablenksystem (43) besteht, welches nach der letzten Kondensorlinse (14) angeordnet ist, und daß der Kippunkt (43k) des Doppelablenksystems (43) in dem vorderen Brennpunkt (17b) der KOE-Linse (17v) liegt.

15. Transmissions-Elektronenmikroskop nach Anspruch 12, dadurch gekennzeichnet, daß das zusätzliche Ablenksystem aus einem Doppelablenksystem (53) besteht, welches vor der letzten Kondensorlinse (14) angeordnet ist, und daß der Kippunkt (53k) des Doppelablenksystems (53) in der (nahezu) konstanten Hauptebene der letzten Kondensorlinse (14) liegt.

16. Transmissions-Elektronenmikroskop nach Anspruch 12, dadurch gekennzeichnet, daß die letzte Kondensorlinse (14) den von dem Ablenksystem (53, 63, 73, 83) ausgelenkten Elektronenstrahl (42) in Richtung der optischen Achse (10) umlenkt.

17. Transmissions-Elektronenmikroskop nach Anspruch 16, dadurch gekennzeichnet, daß der durch die Blende (65) begrenzte Elektronenstrahl (42) durch das zusätzliche Ablenksystem (63) und die letzte Kondensorlinse (14) parallel zur optischen Achse (10) verschoben ist.

18. Transmissions-Elektronenmikroskop nach Anspruch 16, dadurch gekennzeichnet, daß das zusätzliche Ablenksystem (73) in der letzten Crossoverebene (11e) des Kondensorzooms und die Blende (75) zur Begrenzung des Elektronenstrahles vor dieser Crossoverebene (11e) angeordnet ist.

19. Transmissions-Elektronenmikroskop nach Anspruch 16, dadurch gekennzeichnet, daß das zusätzliche Ablenksystem (83) ein Doppelablenksystem (83) ist, welches unterhalb des Crossovers (11c) des Kondensorzooms derart angeordnet ist, daß sein virtueller Kippunkt (83k) in diesem Crossover (11c) liegt.

20. Transmissions-Elektronenmikroskop nach Anspruch 13, dadurch gekennzeichnet, daß das zusätzliche Ablenksystem nach der letzten Kondensorlinse (14) angeordnet ist und daß die eine Blende (95) vor dem zusätzlichen Ablenksystem (93) und die andere Blende (99) vor dem Ablenksystem (16) vor der KOE-Linse angeordnet ist.

21. Transmissions-Elektronenmikroskop nach Anspruch 13, dadurch gekennzeichnet, daß das zusätzliche Ablenksystem ein Doppelablenksystem (103) ist, welches nach der letzten Kondensorlinse (14) angeordnet ist und daß die eine Blende (105) vor und die andere Blende (109) hinter dem Doppelablenksystem (103) angeordnet ist.

22. Transmissions-Elektronenmikroskop nach Anspruch 13, dadurch gekennzeichnet, daß das zusätzliche Ablenksystem aus einem Doppelablenksystem (113) besteht, welches nach der letzten Kondensorlinse (14) angeordnet ist und daß die Blenden (115, 119) innerhalb des Doppelablenksystems (113) angeordnet sind.

## Claims

1. Method of illuminating an object (18) in a transmission electron microscope including an electron source (11) and a plurality of condenser lenses (13a, 13b, 14) for generating an electron beam (12), a single-field condenser objective lens (SFCO lens) (17) and a deflection system (16) arranged upstream of the SFCO lens, characterized by the fact that at least two of the condenser lenses (13a, 13b,) are used so that the electron source (11) is imaged with a varying, pregiven demagnification, that the electron beam (12, 42) is shaped by at least two diaphragms (35, 39; 35, 45; 95, 99), beeing arranged in respective different planes, in a pregiven different manner depending on the respective magnification of the object (by the downstream following imaging stages of the electron microscope), that the shaped electron beam (42c, 62c, 92c) or a component (32) thereof is deflected back into the optical axis (10) by the deflection system (16) upstream of the SFCO lens and that the shaping of the electron beam (12, 42) occurs in dependence upon the magnification so as to cause only an area of the object (18) to be illuminated which is not significantly larger than the imaged area.

2. Method of claim 1, characterized by the fact that the last condenser lens (14) is excited so that the crossover (11c) is imaged into the focal plane (17b) during TEM-operation and is imaged into the entrance image plane (17e) of the SFCO pre-field lens (17v) during STEM-operation.

3. Method of claim 1 or 2, characterized by the fact that a plurality of different sized diaphragms (35a, 35b, 35c), beeing arranged in a single plane, are illuminated by the electron beam (12) and that in dependence upon the respective magnification only one of the component beams (32a, 32b, 32c) having passed through the diaphragms (35a, 35b,35c) is deflected through a further, preferably centrically arranged, selector diaphragm (39) onto the object (18) by the deflection system (16) arranged upstream of the SFCO lens.

4. Method of claim 1 or 2, characterized by the fact that the electron beam (42) limited by a limiting diaphragm (45) is deflected out of the optical axis (10) with varying strength and/or direction depending on the magnification by at least one additional deflection system (43, 53, 63, 73, 83) and is shaped by one of a plurality of different sized diaphragms (35a, 35b, 35c) arranged in a single plane.

5. Method of claim 1 or 2, characterized by the fact that the electron beam (12) is deflected out of the optical axis (10) with varying strength and/or direction depending on the magnification by at least one additonal deflection system (93, 103, 113) and that its cross-section is shaped, more or less, at opposite sides in accordance to the strength of the deflection by two diaphragms (95, 99, 115, 119) being arranged in different planes and displaced with respect to another.

6. Method of claim 4, characterized by the fact that the last condenser lens (14) deflects the electron beam (42), being deflected out by the deflection system (53, 63, 73, 83), into the direction of the optical axis (10).

7. Method of claim 6, characterized by the fact that the electron beam (42), beeing shaped by the diaphragm (65), is shifted parallel to the optical axis (10) by the additional deflection system (63) and by the last condenser lens (14).

8. Method according to one of the claims 1 to 7, characterized by the fact that the deflection system (16) arranged upstream of the SFCO lens and/or the additional deflection system (43; 113) are also used for correcting lateral displacements of the diaphragms (35, 39; 35, 45; 95, 99).

9. Transmission electron microscope including an electron source (11) and a plurality of condenser lenses (13a, 13b, 14) for generating an electron beam (12), a single-field condenser objective lens (SFCO lens) (17) and a deflection system (16) arranged upstream of the SFCO lens, characterized by the fact that at least two of the condenser lenses (13a, 13b,) are used so that the electron source (11) is imaged with a varying, pregiven demagnification, that the electron beam (12, 42) is shaped by at least two diaphragms (35, 39; 35, 45; 95, 99), beein arranged in respective different planes, in a pregiven different manner depending on the respective magnification of the object (by the downstream following imaging stages of the electron microscope), that the shaped electron beam (42c, 62c, 92c) or a component (32) thereof is deflected back into the optical axis (10) by the deflection system (16) upstream of the SFCO lens and that the shaping of the electron beam (12, 42) occurs in dependence upon the magnification so as to cause only an area of the object (18) to be illuminated which is not significantly larger than the imaged area.

10. Transmission electron microscope of claim 9, characterized by the fact that the last condenser lens (14) is excited so that the crossover (11c) is imaged into the focal plane (17b) during TEM-operation and is imaged into the entrance image plane (17e) of the SFCO pre-field lens (17v) during STEM-operation.

11. Transmission electron microscope of claim 9 or 10, characterized by the fact that a plurality of different sized diaphragms (35a, 35b, 35c), beeing arranged in a single plane, are illuminated by the electron beam (12) and that in dependence upon the respective magnification only one of the component beams (32a, 32b, 32c) having passed through the diaphragms (35a, 35b,35c) is deflected through a further, preferably centrically arranged, selector diaphragm (39) onto the object (18) by the deflection system (16) upstream of the SFCO lens.

12. Transmission electron microscope of claim 9 or 10, characterized by the fact that the electron beam (42) limited by a limiting diaphragm (45) is deflected out of the optical axis (10) with varying strength and/or direction depending on the magnification by at least one additional deflection system (43, 53, 63, 73, 83) and is shaped by one of a plurality of different sized diaphragms (35a, 35b, 35c) arranged in a single plane.

13. Transmission electron microscope of claim 9 or 10, characterized by the fact that the electron beam (12) is deflected out of the optical axis (10) with varying strength and/or direction depending on the magnification by at least one additional deflection system (93, 103, 113) and that its cross-section is shaped, more or less, at opposite sides in accordance to the strength of the deflection by two diaphragms (95, 99, 115, 119) being arranged in different planes and displaced with respect to another.

14. Transmission electron microscope according to claim 12, characterized by the fact that the additional deflection system comprises a double deflection system (43) disposed downstream of the last condenser lens (14) and that the pivot point (43k) of the double deflection system (43) is lieing in the front focal point (17b) of the SFCO lens (17v).

15. Transmission electron microscope according to claim 12, characterized by the fact that the additional deflection system comprises a double deflection system (53) disposed upstream of the last condenser lens (14) and that the pivot point (53k) of the double deflection system (53) is lieing in the (approximately) constant principal plane of the last condenser lens (14).

16. Transmission electron microscope according to claim 12, characterized by the fact that the last condenser lens (14) deflects the electron beam (42) which is deflected out by the deflection system (53, 63, 73, 83) toward the direction of the optical axis (10).

17. Transmission electron microscope according to claim 16, characterized by the fact that the electron beam (42), beeing limited by the diaphragm (65), is displaced parallel to the optical axis (10) by the additional deflection system (63) and the last condenser lens (14).

18. Transmission electron microscope according to claim 16, characterized by the fact that the additional deflection system (73) is mounted in the last crossover plane (11e) of the zoom of the condenser lenses and that the diaphragm (75) for limiting the electron beam is mounted ahead of this crossover plane (11e).

19. Transmission electron microscope according to claim 16, characterized by the fact that the additional deflection system (83) is a double deflection system (83) which is mounted below the crossover (11c) of the zoom of the condenser lenses so as to cause its virtual pivot point (83k) to lie in this crossover (11c).

20. Transmission electron microscope according to claim 13, characterized by the fact that the additional deflection system is mounted downstream of the last condenser lens (14) and that one of the diaphragms (95) is mounted upstream of the additional deflection system (93) and that the other diaphragm (99) is mounted upstream of the deflection system (16) ahead of the SFCO lens.

21. Transmission electron microscope according to claim 13, characterized by the fact that the additional deflection system is a double deflection system (103) which is mounted downstream of the last condenser lens (14) and that one of the diaphragms (105) is mounted ahead and the other diaphragm (109) is mounted after the double deflection system (103).

22. Transmission electron microscope according to claim 13, characterized by the fact that the additional deflection system comprises a double deflection system (113) which is mounted downstream of the last condenser lens (14) and that the diaphragms (115, 119) are mounted within the double deflection system (113).

## Revendications

1. Procédé pour éclairer un objet (18) dans un microscope électronique à transmission, comportant une source d'électrons (11) et plusieurs lentilles formant condenseurs (13a,13b,14) pour produire un faisceau d'électrons (12), une lentille à champ unique d'objectif formant condenseur (lentille KOE) (17) et un système de déviation (16) pour la lentille KOE, caractérisé en ce qu'on utilise au moins deux lentilles formant condenseurs (13a,13b) de manière qu'elles forment l'image de la source d'électrons (11) avec une réduction variable pouvant être prédéterminée, que le faisceau d'électrons (12,14) est bloqué, d'une manière variable prédéterminée, par au moins deux diaphragmes (35,39;35,45;95,99) disposés dans des plans différents, en fonction du grandissement respectif de l'objet (au moyen des étages successifs de formation d'images du microscope électronique), que le faisceau d'électrons diaphragmé (42c, 62c, 92c) ou une partie (32c) de ce faisceau est renvoyé à nouveau en direction de l'axe optique (10) par le système de déviation (16) en amont de la lentille (KOE) et que la diaphragmation du faisceau d'électrons (12,42) s'effectue en fonction du grandissement respectif à un degré tel qu'en permanence seule est éclairée une zone de l'objet (18), qui n'est pas nettement plus étendue que la zone dont l'image est formée.

2. Procédé selon la revendication 1, caractérisé en ce que la dernière lentille formant condenseur (14) est excitée de telle sorte que l'image du point de croisement (11c) est formée dans le plan focal (17b), dans le cas du fonctionnement TEM et dans le plan image d'entrée (17e) de la lentille de champ amont KOE (17b), dans le cas du fonctionnement STEM.

3. Procédé selon la revendication 1 ou 2, caractérisé en ce que le faisceau d'électrons (12) éclaire plusieurs diaphragmes (35a,35b,35c) disposés dans un plan et possédant des tailles différentes et que respectivement seul le faisceau partiel (32a,32b,32c), qui traverse l'un des diaphragmes (35a,35b,35c), est dirigé, par le système de déviation (16) en amont de la lentille KOE, en fonction du grandissement respectif, sur l'objet (18) au moyen d'un autre diaphragme de sélection (39) installé de préférence en position centrée.

4. Procédé selon la revendication 1 ou 2, caractérisé en ce que le faisceau d'électrons (42) limité par un diaphragme de limitation (45) est dévié à partir de l'axe optique (10) en fonction du grandissement respectif avec une intensité et/ou une direction variables et est diaphragmé par l'un de plusieurs diaphragmes (35a,35b,35c) qui ont des tailles différentes et sont situés dans un plan.

5. Procédé selon la revendication 1 ou 2, caractérisé en ce que le faisceau d'électrons (12) est dévié par au moins un système supplémentaire de déviation (93,103,113) à partir de l'axe optique (10), à un degré variable, en fonction du grandissement respectif et que sa section transversale est diaphragmée plus ou moins fortement par deux diaphragmes (95,99; 115,119), disposés dans des plans différents et décalés l'un par rapport à l'autre, sur des côtés réciproquement opposés, en fonction de l'amplitude de la déviation.

6. Procédé selon la revendication 4, caractérisé en ce que la dernière lentille formant condenseur (14) renvoie en direction de l'axe optique (10) le faisceau d'électrons (42) dévié par le système de déviation (53,63, 73,83).

7. Procédé selon la revendication 6, caractérisé en ce que le faisceau d'électrons (42) délimité par le diaphragme (65) est décalé parallèlement à l'axe optique (10) par le système supplémentaire de déviation (63) et par la dernière lentille formant condenseur (14).

8. Procédé selon l'une des revendications 1 à 7, caractérisé en ce que le système de déviation (16) est utilisé en amont de la lentille KOE et/ou que le système supplémentaire de déviation (43;113) est utilisé en supplément pour corriger des décalages latéraux des diaphragmes (35,39; 35,45; 95,99).

9. Microscope électronique à transmission, comportant une source d'électrons (11) et plusieurs lentilles formant condenseurs (13a,13b,14) pour produire un faisceau d'électrons (12), une lentille à champ unique d'objectif formant condenseur (lentille KOE) (17) et un système de déviation (16) pour la lentille KOE, caractérisé en ce qu'on utilise au moins deux lentilles formant condenseurs (13a,13b) de manière qu'elles forment l'image de la source d'électrons (11) avec une réduction variable pouvant être prédéterminée, que le faisceau d'électrons (12,14) est bloqué, d'une manière variable prédéterminée, par au moins deux diaphragmes (35,39;35,45;95,99) disposés dans des plans différents, en fonction du grandissement respectif de l'objet (au moyen des étages successifs de formation d'images du microscope électronique), que le faisceau d'électrons diaphragmé (42c, 62c, 92c) ou une partie (32c) de ce faisceau est renvoyé et ramené à nouveau en direction de l'axe optique (10) par le système de déviation (16) en amont de la lentille (KOE) et que la diaphragmation du faisceau d'électrons (12,42) s'effectue en fonction du grandissement respectif à un degré tel qu'en permanence seule est éclairée une zone de l'objet (18), qui n'est pas nettement plus étendue que la zone dont l'image est formée.

10. Microscope électronique à transmission selon la revendication 9, caractérisé en ce que la dernière lentille formant condenseur (14) est excitée de telle sorte que l'image du point de croisement (11c) est formée dans le plan focal (17b), dans le cas du fonctionnement TEM et dans le plan image d'entrée (17e) de la lentille de champ amont KOE (17b), dans le cas du fonctionnement STEM.

11. Microscope électronique à transmission selon la revendication 9 ou 10, caractérisé en ce que le faisceau d'électrons (12) éclaire plusieurs diaphragmes (35a,35b,35c) disposés dans un plan et possédant des tailles différentes et que respectivement seul le faisceau partiel (32a,32b,32c), qui traverse l'un des diaphragmes (35a,35b,35c), est dirigé, par le système de déviation (16) en amont de la lentille KOE, en fonction du grandissement respectif, sur l'objet (18) au moyen d'un autre diaphragme de sélection (39) installé de préférence en position centrée.

12. Microscope électronique à transmission selon la revendication 9 ou 10, caractérisé en ce que le faisceau d'électrons (42) limité par un diaphragme de limitation (45) est dévié à partir de l'axe optique (10) en fonction du grandissement respectif avec une intensité et/ou une direction variables et est diaphragmé par l'un de plusieurs diaphragmes (35a,35b,35c) qui ont des tailles différentes et sont situés dans un plan.

13. Microscope électronique à transmission selon la revendication 9 ou 10, caractérisé en ce que le faisceau d'électrons (12) est dévié par au moins un système supplémentaire de déviation (93,103,113) à partir de l'axe optique (10), à un degré variable, en fonction du grandissement respectif et que sa section transversale est diaphragmée plus ou moins fortement par deux diaphragmes (95,99; 115,119), disposés dans des plans différents et décalés l'un par rapport à l'autre, sur des côtés réciproquement opposés, en fonction de l'amplitude de la déviation.

14. Microscope électronique à transmission selon la revendication 12, caractérisé en ce que le système supplémentaire de déviation est constitué par un système de déviation double (43), qui est disposé en aval de la dernière lentille formant condenseur (14) et que le point de basculement (43k) du système de déviation double (43) est situé au niveau du foyer avant (17b) de la lentille KOE (17v).

15. Microscope électronique à transmission selon la revendication 12, caractérisé en ce que le système supplémentaire de déviation est constitué par un système de déviation double (53), qui est disposé en amont de la dernière lentille formant condenseur (14), et que le point de basculement (53k) du système de déviation double (53) est situé dans le plan principal (approximativement) constant de la dernière lentille formant condenseur (14).

16. Microscope électronique à transmission selon la revendication 12, caractérisé en ce que la dernière lentille formant condenseur (14) dévie en direction de l'axe optique (10) le faisceau d'électrons (42) dévié par le système de déviation (53,63,73,83).

17. Microscope électronique à transmission selon la revendication 16, caractérisé en ce que le faisceau d'électrons (42) limité par le diaphragme (65) est décalé par le système supplémentaire de déviation (63) et par la dernière lentille formant condenseur (14), parallèlement à l'axe optique.

18. Microscope électronique à transmission selon la revendication 16, caractérisé en ce que le système supplémentaire de déviation (73) est disposé dans le dernier plan (11e) du point de croisement du zoom du condenseur et que le diaphragme (75) servant à limiter le faisceau d'électrons est disposé en amont de ce plan (11e) du point de croisement.

19. Microscope électronique à transmission selon la revendication 16, caractérisé en ce que le système supplémentaire de déviation (83) est un système de déviation double (83), qui est disposé au-dessous du point de croisement (11c) du zoom du condenseur de sorte que son point de croisement virtuel (83k) est situé en ce point de croisement (11c).

20. Microscope électronique à transmission selon la revendication 13, caractérisé en ce que le système supplémentaire de déviation est disposé en aval de la dernière lentille formant condenseur (14), et qu'un diaphragme (95) est disposé en amont du système supplémentaire de déviation (93) et que l'autre diaphragme (99) est disposé en amont du système de déviation (16) en amont de la lentille KOE.

21. Microscope électronique à transmission selon la revendication 13, caractérisé en ce que le système de déviation supplémentaire est un système de déviation double (103), qui est disposé en aval de la dernière lentille formant condenseur (14) et qu'un diaphragme (105) est disposé en amont du système de déviation double (103) et que l'autre diaphragme (109) est disposé en aval du système de déviation double (103).

22. Microscope électronique à transmission selon la revendication 13, caractérisé en ce que le système supplémentaire de déviation est constitué par un système de déviation double (113), qui est disposé en aval de la dernière lentille formant condenseur (14) et que les diaphragmes (115,119) sont disposés à l'intérieur du système de déviation double (113).
